(19) Europäisches Patentamt
European Patent Office
Office européen des brevets

(11) **EP 2 600 141 B1**

(12) **FASCICULE DE BREVET EUROPEEN**

(45) Date de publication et mention de la délivrance du brevet:
**14.05.2014 Bulletin 2014/20**

(51) Int Cl.:
***G01N 22/02*** *(2006.01)*

(21) Numéro de dépôt: **12194471.4**

(22) Date de dépôt: **27.11.2012**

(54) **Appareil de contrôle d'une surface et procédé associé**

Prüfgerät einer Oberfläche, und entsprechendes Verfahren

Apparatus for controlling a surface and related method

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.12.2011 FR 1103695**

(43) Date de publication de la demande:
**05.06.2013 Bulletin 2013/23**

(73) Titulaire: **Dassault Aviation**
**75008 Paris (FR)**

(72) Inventeur: **Leflour, Gérard**
**75016 Paris (FR)**

(74) Mandataire: **Jacobson, Claude**
**Cabinet Lavoix**
**2, Place d'Estienne d'Orves**
**75441 Paris Cedex 09 (FR)**

(56) Documents cités:
**WO-A2-2004/074823     US-A- 2 999 982**
**US-A- 4 123 703          US-A1- 2002 011 947**
**US-A1- 2003 132 760**

EP 2 600 141 B1

**Description**

La présente invention concerne un appareil de contrôle d'une surface, selon le préambule de la revendication 1.

Un tel appareil est destiné à contrôler les hétérogénéités et/ou les défauts locaux qui peuvent être présents sur des surfaces.

En particulier, un tel appareil est destiné à déterminer l'homogénéité radioélectrique d'une surface, en déterminant les variations des propriétés radioélectriques de la surface par une méthode de contrôle non destructive.

Une bonne homogénéité radioélectrique de surface peut être requise dans de nombreuses applications, notamment dans celles destinées à réaliser et à intégrer des antennes, dans l'isolation d'équipements sensibles aux champs forts, et dans la réduction de la diffusion d'ondes éclairant ces surfaces.

En particulier, les réflecteurs paraboliques utilisés dans certaines antennes à grands gains doivent présenter une conductivité surfacique homogène. Faute d'une telle homogénéité, les défauts de conductivité provoquent des dispersions du rayonnement électromagnétique qui accroissent les taux d'ondes stationnaires et amplifient les interactions entre systèmes voisins.

Les radômes présents en regard des antennes doivent au contraire être transparents radioélectriquement. Des discontinuités de transparence diminuent l'intensité des signaux émis et reçus et diffusent les ondes hors des secteurs angulaires d'intérêt.

Par ailleurs, dans le cas où une partie du système antennaire doit être isolée, un matériau absorbant peut être utilisé pour revêtir le système antennaire. Il est alors nécessaire que la réflectivité de surface soit homogène.

Pour détecter des défauts radioélectriques de surface, il est connu d'examiner les variations des propriétés radioélectriques de ces surfaces.

Dans ce cadre, des techniques non destructives sont utilisées. Parmi ces techniques, il est connu d'utiliser des courants de Foucault à l'aide d'une bobine en engendrant, à proximité de la surface, un champ magnétique pénétrant dans le matériau. Cette pénétration génère des courants induits qui sont captés par la bobine ou mesurés par une bobine voisine.

Les courants induits traduisent la conductivité et la perméabilité magnétique du matériau et influencent l'impédance propre de la bobine ou l'impédance mutuelle entre deux bobines du dispositif.

Dans certains cas, pour améliorer la qualité de la mesure, il est connu d'effectuer des mesures localisées de réflectivité électromagnétique. Ces mesures peuvent être effectuées à l'aide d'une antenne et d'un réflecteur, ou à l'aide d'un guide d'ondes.

Des techniques radars peuvent également être utilisées en déplaçant un couple d'antennes d'émission et de réception par rapport à une scène pour obtenir une résolution spatiale selon l'axe de déplacement.

Toutefois, les techniques existantes présentent de nombreuses limitations. Ainsi, la technique utilisant les courants de Foucault ne permet le contrôle que de surfaces conductrices ou magnétiques. En outre, pour des fréquences supérieures à 300 MHz, les bobines utilisées comme capteurs génèrent un rayonnement spatial et deviennent sensibles à des échos externes à la zone d'intérêt.

Des mesures localisées de réflectivité électromagnétiques sont limitées en résolution, notamment compte tenu de la largeur de la tache d'éclairement qui est typiquement de l'ordre d'une demi-longueur d'onde. Ces méthodes de mesure ne sont donc pas aptes à détecter des discontinuités d'impédances localisées, résultant par exemple d'une fente liée à une craquelure dans une couche de métallisation.

Quant aux techniques radars, elles sont coûteuses et parfois difficiles à mettre en oeuvre, notamment pour éviter les échos externes qui satureraient la mesure. Il est généralement nécessaire d'effectuer les mesures dans une enceinte anéchoïque.

De plus, pour obtenir une bonne résolution spatiale sur la détection des défauts, la bande de fréquence de mesures doit être large, ce qui conduit à des temps de mesure importants.

US 2003/132760 décrit un appareil selon le préambule de la revendication 1.

US 4,123,703 décrit un détecteur dépourvu de cavité comportant deux bandes métalliques parallèles pour la détection de défauts.

US 2 999 982 décrit un dispositif de détection de défauts par défilement à grande vitesse basée sur l'effet Doppler.

Un but de l'invention est donc d'obtenir un appareil de mesure non destructive de défauts de propriétés radioélectriques de surface, la mesure étant très sensible aux défauts détectés, mais peu sensible à l'environnement extérieur, la méthode étant utilisable sur une large gamme de fréquences, tout en étant simple à mettre en oeuvre.

A cet effet, l'invention a pour objet un appareil selon la revendication 1.

L'appareil selon l'invention peut comprendre une ou plusieurs des caractéristiques des revendications 2 à 11.

L'invention a également pour objet un procédé selon la revendication 12 ou 13.

L'invention sera mieux comprise à la lecture de la description qui va suivre, donnée uniquement à titre d'exemple, et faite en se référant aux dessins annexés, sur lesquels :

- la Figure 1 est une vue schématique en coupe partielle d'un appareil de contrôle selon l'invention destiné à contrôler une surface ;
- la Figure 2 est une vue schématique de l'ensemble de traitement du signal reçu par l'appareil de la Figure 1 ;

- la Figure 3 illustre le comportement fréquentiel d'un filtre utilisé dans l'ensemble de traitement de la Figure 2 ;
- la Figure 4 illustre un premier exemple d'affichage du signal produit par l'appareil de la Figure 1, lors du passage sur un défaut de surface ; et
- la Figure 5 est une vue analogue à la Figure 4 lors d'un balayage spatial d'une surface donnée.

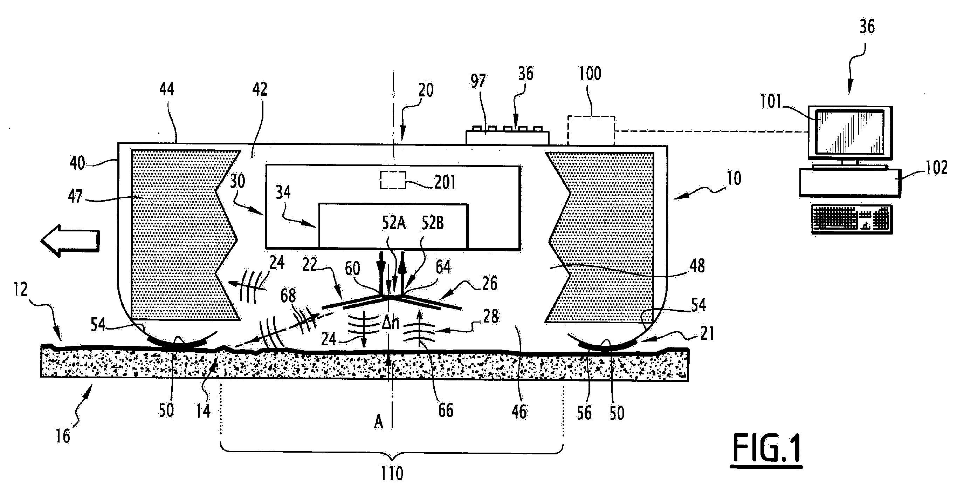

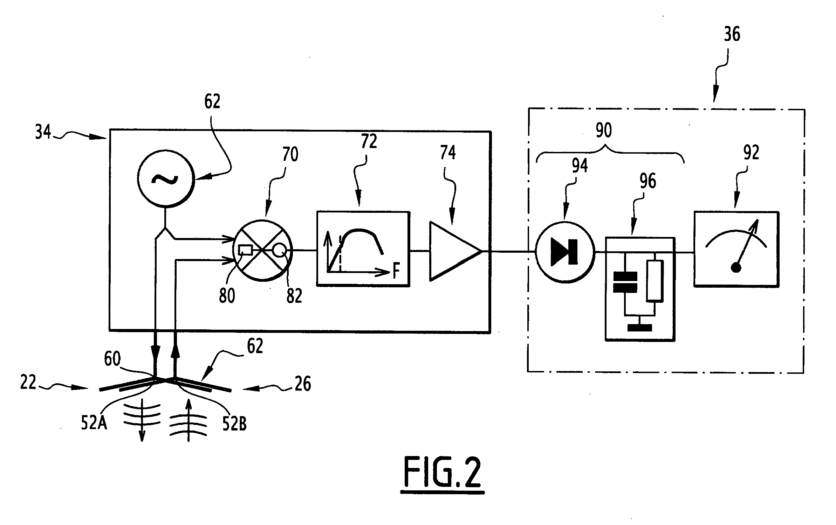

Un premier appareil 10 de contrôle d'une surface 12 selon l'invention est illustré par les Figures 1 et 2.

Cet appareil 10 est destiné à détecter des défauts d'uniformité de l'impédance de la surface 12 par déplacement relatif par rapport à la surface 12.

Dans cet exemple, l'appareil 10 est un appareil portable, qui peut être déplacé par la main d'un utilisateur, ou par un bras robotisé.

La surface 12 est une surface sensiblement homogène radio-électriquement, qui présente des défauts ponctuels 14. Ces défauts ponctuels 14 sont susceptibles d'être détectés par l'appareil 10 selon l'invention.

La surface 12 est par exemple une surface conductrice, telle qu'une surface métallique formée dans la masse d'une pièce 16, ou formant un revêtement de la pièce 16. En variante, la surface 12 est isolante. Elle est par exemple formée à base d'un matériau diélectrique.

La pièce 16, dont l'état de surface est contrôlé, est par exemple un réflecteur parabolique utilisé dans une antenne, ou un radôme destiné à être monté sur une installation fixe ou sur une plateforme mobile tel qu'un aéronef.

En variante, la pièce 16 est une pièce de revêtement d'un moyen de mesure radioélectrique, comme un radar, ou une paroi conductrice destinée à séparer un générateur de fort rayonnement électromagnétique, d'un équipement sensible au rayonnement par effet de cage de Faraday.

L'appareil 10 détecte des variations faibles d'impédance de la surface 12.

L'impédance d'une surface caractérise la réponse de celle-ci à une onde électromagnétique.

Dans tout ce qui suit, l'impédance est définie par rapport entre les champs électriques et magnétiques à l'interface entre la surface et le milieu externe. Les champs se décrivent par une amplitude et une phase selon leur direction de polarisation.

L'impédance est calculée par une valeur complexe pour une fréquence donnée. Le coefficient de réflexion R d'une onde électromagnétique établit le rapport d'intensité entre une onde plane réfléchie et une onde plane incidente.

Le coefficient R se déduit de l'impédance Z moyenne de la surface par la relation :

$$R = \frac{Z-1}{Z+1} \quad (1).$$

L'impédance Z se définit en tout point de la surface 12. Sa valeur moyenne caractérise la réflexion spéculaire d'une onde et ses fluctuations caractérisent la réflexion diffuse.

L'appareil 10 est destiné à mesurer de manière sensible les discontinuités locales de l'impédance de surface Z, afin de détecter les défauts locaux 14 sur cette surface.

Par ce contrôle de l'uniformité de l'impédance de surface, il est possible indirectement de localiser des défauts affectant d'autres propriétés d'intérêt, telles que les propriétés mécaniques, les épaisseurs d'une couche éventuelle de protection, la résistance à l'usure et à la corrosion, etc ...

En référence à la Figure 1, l'appareil 10 selon l'invention comporte un support mobile 20, et un ensemble 21 de guidage de déplacement du support mobile 20 tangentiellement par rapport à la surface 12 pour permettre un balayage de la surface 12 à une vitesse de déplacement tangentielle V.

L'appareil 10 comporte en outre un émetteur 22 propre à engendrer un signal électromagnétique 24 destiné à être dirigé vers la surface 12 et un récepteur 26 de détection d'un signal réfléchi 28 par la surface 12 à partir du signal d'émission 24.

L'émetteur 22 et le récepteur 26 sont portés par le support 20 et sont mobiles conjointement avec celui-ci.

L'appareil 10 comporte en outre une unité 30 de commande de l'émetteur 22 et du récepteur 26, et une unité 34 d'extraction, dans le signal reçu par le récepteur 26, d'un signal extrait représentatif d'une variation d'impédance locale de la surface.

Dans cet exemple, l'appareil 10 comporte en outre une unité 36 de traitement et d'affichage du signal extrait représentatif de la variation d'impédance locale de la surface.

Le support 20 est formé par un boîtier creux 40 délimitant une cavité interne 42 de réception de l'émetteur 22 et du récepteur 26.

Le boîtier 40 comporte une paroi métallique 44 creuse délimitant la cavité 42. La paroi métallique 44 délimite la cavité 42 vers le haut à l'écart de la surface 12, et à la périphérie de la cavité 42, autour de l'émetteur 22, du récepteur 26 et de l'unité centrale 30.

La paroi métallique 44 délimite une ouverture inférieure 46 par laquelle débouche la cavité 42. L'ouverture inférieure 46 est destinée à être positionnée en regard de la surface 12 à contrôler.

Selon l'invention, le support 20 comporte un bouclier absorbant 47 disposé sur la paroi 44 dans la cavité 42. Le bouclier 47 s'étend à la périphérie de la cavité 42, autour de l'émetteur 22 et du récepteur 26. Il est formé par exemple par un anneau de matériau absorbant les ondes électromagnétiques à la fréquence d'émission du récepteur 22. Ce matériau absorbant est par exemple une mousse contenant des particules de carbone ou une matrice silicone ou uréthane chargée de particules magnétiques. De tels matériaux sont commercialisés par la société Emerson et Cuming Microwave Products sous la marque Eccosorb.

Le bouclier 47 délimite intérieurement un passage central 48. L'unité de calcul 30 et l'unité de traitement 34, l'émetteur 22 et le récepteur 26 sont disposés dans le passage central 48.

Dans l'exemple représenté sur la Figure 1, l'ensemble de guidage 21 du support 20 sur la surface 12 comporte des organes 50 de contact avec la surface 12 faisant saillie à partir du support 20.

Les organes de contact 50 sont propres à maintenir le support 20, l'émetteur 22, et le récepteur 26 sensiblement parallèles localement par rapport à la surface 12, à une distance faible et déterminée par rapport à la surface 12 .

Ainsi, l'émetteur 22 et le récepteur 26 peuvent être déplacés tangentiellement par rapport à la surface 12 pour la balayer et détecter des défauts ponctuels tout en conservant la distance séparant l'émetteur 22 et le récepteur 26 de la surface 12 sensiblement constante.

Les organes d'appui 50 sont configurés pour maintenir l'émetteur 22 et le récepteur 26, et en particulier, leurs centres de phase 52A, 52B qui définissent l'origine ou la capture des rayonnements, à une distance de la surface 12 comprise entre 0,1 fois et 1 fois la longueur d'onde $\lambda_e$ d'émission du rayonnement émis par l'émetteur 22, avantageusement à une distance comprise entre 0,2 fois et 0,5 fois la longueur d'onde $\lambda_e$.

En particulier, la différence de hauteur notée $\Delta h$ sur la Figure 1 entre les centres 52A, 52B respectifs de phase de l'émetteur 22 et du récepteur 26 et le plan P défini par les points des organes 50 les plus éloignés verticalement des centres 52A, 52B sur les organes 50 est comprise entre 0,1 fois et 1 fois la longueur d'onde $\lambda_e$ d'émission du rayonnement émis par l'émetteur 22, notamment entre 0,2 fois et 0,5 fois la longueur d'onde d'émission $\lambda_e$.

Pour les fréquences usuelles d'émission utilisées par l'appareil 10, cette différence de hauteur $\Delta h$ est par exemple comprise entre 6 mm et 1,5 mm.

Dans l'exemple représenté sur la Figure 1, les organes de contact 50 sont formés par des patins 54, qui font saillie vers le bas à partir de la paroi métallique 44.

Les patins 54 présentent une surface inférieure 56 de contact avec la surface 12 qui est destinée à glisser sur la surface 12. La surface inférieure 56 est par exemple munie d'un revêtement anti-adhérent.

Comme précisé plus haut, l'émetteur 22 est disposé dans la cavité 42 délimitée par le support 20. Il est avantageusement disposé au voisinage d'un axe central A-A' de la cavité 42.

L'émetteur 22 comporte une antenne d'émission 60 propre à émettre un signal d'émission formé d'un rayonnement électromagnétique à une fréquence $F_e$ comprise entre 100 MHz et 1000 GHz. Plus généralement, le signal peut présenter une fréquence d'émission $F_e$ supérieure à 1000 GHz.

L'antenne d'émission 60 émet le signal 24 dans toutes les directions, et notamment directement vers la surface 12, de manière rasante vers la surface 12, et vers la paroi métallique 44 du support 20.

L'antenne 60 est par exemple formée d'un ou plusieurs éléments rayonnants. L'antenne 60 est avantageusement compacte d'une taille inférieure à une demi-longueur d'onde et peut présenter une très faible bande de passante autour de la fréquence $F_e$.

Dans un mode de réalisation particulier, l'antenne 60 est une antenne imprimée sur un diélectrique, désignée par le terme « antenne patch ».

L'émetteur 22 comporte en outre un oscillateur 62 (visible sur la Figure 2) propre à engendrer le signal d'émission de manière périodique à une fréquence d'émission $F_e$.

L'oscillateur 62 est préférentiellement un oscillateur à fréquence fixe, ce qui simplifie et réduit les coûts du système de contrôle. En particulier, l'oscillateur 62 est choisi parmi un oscillateur à résonateur diélectrique (désigné par l'acronyme anglais « DRO » pour « Dielectric Resonator Oscillator » en particulier un oscillateur à résonateur diélectrique en céramique.

Un tel résonateur est par exemple commercialisé par la Société General Electronic Devices, San Marcos CA USA, sous le nom DRO. Ces résonateurs sont notamment utilisés dans les oscillateurs micro-ondes, en raison de leur robustesse, de leur faible coût et de leur petite taille. Ils possèdent une bonne stabilité de phase exprimée typiquement par une densité spectrale mono latérale de puissance (ou SSB phase noise) inférieure à -60 dBc/Hz à un offset en fréquence de 10Hz.

Le récepteur 26 comporte une antenne de réception 64 propre à mesurer un signal reçu depuis la surface 12 sur une bande passante qui n'a pas besoin d'excéder $10^{-8}$ fois la fréquence d'émission.

Ainsi, l'antenne de réception 64 est propre à recevoir le signal réfléchi 66 à une fréquence stable dans le temps, lié à l'impédance moyenne de la surface 12 sur l'ensemble de la zone éclairée par le signal d'émission 24, et un signal 68 lié aux discontinuités radioélectriques ou géométriques provoquées par les défauts 14 qui affectent l'impédance de surface.

Le signal réfléchi 66 est généralement reçu à la même fréquence que la fréquence d'émission $F_e$ du signal d'émission 24.

Le signal 68 lié aux discontinuités radioélectriques est caractérisé par des fluctuations d'amplitude et par un décalage fréquentiel dû à la vitesse de rapprochement relatif $V_r$ de l'appareil 10 par rapport aux défauts 14.

Cette vitesse de rapprochement $V_r$ est égale à la vitesse de déplacement tangentiel V de l'appareil 10 le long de la surface 12, multipliée par le cosinus de l'angle Φ formé entre la direction de propagation du signal 68 et la tangente locale à la surface 12.

Compte tenu de la faible hauteur Δh, l'angle Φ est généralement inférieur à 45°, ce qui permet d'accroître la vitesse de rapprochement $V_r$.

Ainsi, l'antenne de réception 64 est propre à recevoir une composante fréquentielle décalée de la fréquence d'émission représentative du décalage Doppler entre la fréquence d'émission $F_e$ et la fréquence de réception $F_r$.

Ce décalage Doppler est généralement donné par la différence $F_r$ - $F_e$ entre la fréquence de réception et la fréquence d'émission et peut être approché par l'équation :

$$F_r - F_e = 2\ V_r\ F_e/c\ (2),$$

où c est la vitesse de propagation du rayonnement électromagnétique dans le vide.

Par ailleurs, les antennes 60, 64 sont logées dans le passage central 48 et dans la cavité 42 pour confiner à la fois les champs émis par l'antenne d'émission 60 et le champ réfléchi sur la surface 12 dans la cavité 42. Ceci est obtenu par l'intermédiaire de la paroi conductrice 40 formant cage de Faraday et par l'intermédiaire du bouclier absorbant 47.

Typiquement, la distance de propagation maximale des champs émis est inférieure à 5 fois la longueur d'onde du signal émis.

L'unité de commande 30 est propre à piloter l'oscillateur 62 pour émettre un signal d'émission à la fréquence d'émission $F_e$. L'unité de commande 30 est propre à recueillir le signal reçu par l'antenne de réception 64 et à le transmettre à l'unité d'extraction 34.

Comme précisé plus haut, l'unité d'extraction 34 est apte à extraire dans le signal reçu par le récepteur 26, une composante fréquentielle décalée de la fréquence d'émission $F_e$ résultant d'une variation d'impédance locale de la surface 12 mesurée.

En particulier, l'unité d'extraction 34 est destinée à extraire un signal représentatif du décalage Doppler entre la fréquence d'émission $F_e$ et la fréquence de réception $F_r$ lorsque l'appareil 10 est déplacé tangentiellement par rapport à la surface 12.

Dans un mode de réalisation avantageux, visible sur la Figure 2, l'ensemble d'extraction 34 comporte un composant hétérodyne apte à réaliser un mélange de fréquences entre le signal reçu par le récepteur 62 et le signal émis par l'émetteur 22.

Dans les exemples illustrés dans la Figure 2, l'unité d'extraction 34 comporte un mixeur 70, propre à mélanger le signal reçu avec une portion du signal d'émission, et à engendrer un signal de battement à la composante fréquentielle décalée $F_r$ - $F_e$ représentative du décalage Doppler.

L'unité d'extraction 34 comporte en outre un filtre 72 propre à supprimer la composante à la fréquence d'émission $F_e$ provenant de l'impédance moyenne mesurée et à supprimer les composantes Doppler provenant d'un décalage de l'émetteur 22 et du récepteur 26 dans un sens perpendiculaire à la surface 12.

Ceci permet d'engendrer un signal extrait représentatif de la composante fréquentielle décalée, correspondant au décalage Doppler entre la fréquence d'émission et la fréquence de réception, à la vitesse tangentielle de rapprochement $V_r$ de l'appareil 10 sur la surface.

Avantageusement, l'unité d'extraction 34 comporte en outre un amplificateur de sortie 74 propre à adapter le signal extrait en niveau et en impédance pour le distribuer à l'unité d'affichage 36 sous forme d'un signal extrait représentatif d'une variation d'impédances locales de la surface.

En référence à la Figure 2, le mixeur 70 comporte un mélangeur 80 recevant au moins une partie du signal reçu $S_r(t) = A_r \cdot \cos(2\pi \cdot F_r \cdot t)$ pour le mélanger avec une partie du signal d'émission $S_e(t) = A_e \cdot \cos(2\pi \cdot F_e \cdot t)$, et au moins un composant non linéaire 82 propre à engendrer des termes quadratiques générateurs d'un battement basse fréquence proportionnel au décalage Doppler $F_e$-$F_r$.

Le mélangeur 80 est propre à engendrer un signal combiné comportant la somme des termes $S_r(t)$ et $S_e(t)$.

Le composant non linéaire 82 est par exemple une diode. Il est propre à faire apparaître des termes quadratiques générateurs d'un battement basse fréquence proportionnel à $A_r \cdot A_e \cdot \cos[2\pi \cdot (F_r - F_e) \cdot t]$ qui sont inclus dans le signal de sortie.

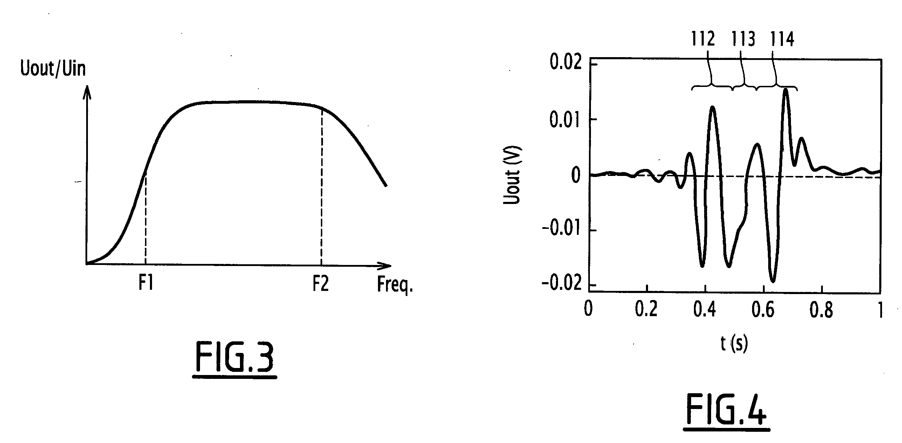

Le filtre 72 est avantageusement un filtre qui présente une première fréquence de coupure basse F1, illustrée par la Figure 3. La fréquence F1 correspond à un décalage Doppler à une vitesse de déplacement minimal. Cette vitesse $V_{min}$ est par exemple comprise entre 5 mm/s et 20 cm/s. La fréquence de coupure basse est calculée par l'équation suivante F1= 2 x $V_{min}$ x $F_e$/c

Le filtre 72 présente une deuxième fréquence de coupure haute F2, propre à éliminer la fréquence d'émission Fe porteuse et d'éventuelles sources d'émission parasites de l'environnement. A cet effet, la fréquence haute est choisie en fonction d'une vitesse maximale de déplacement $V_{max}$ et est calculée par l'équation F2= 2 x $V_{max}$ x $F_e$ /c.

Le filtre 72 est ainsi apte à isoler le signal extrait représentatif de la composante fréquentielle décalée correspondant au décalage Doppler entre la fréquence d'émission et la fréquence de réception, à la vitesse de déplacement de l'appareil 10 sur la surface.

L'amplificateur 74 est propre à traiter le signal filtré issu du filtre 72 pour l'adapter en niveau et en impédance, afin de le distribuer sans altération à l'unité d'affichage 36. Avantageusement, le signal produit en sortie de l'amplificateur 74, qui correspond au signal extrait par l'unité 34 est un signal dit à fréquence intermédiaire nulle ou en « Fi0 » ou « en bande de base ».

Dans l'exemple représenté sur la Figure 2, l'unité de traitement et d'affichage 36 comporte un ensemble 90 de détection d'enveloppe du signal extrait issu de l'unité 34 et un afficheur 92.

Dans cet exemple, l'ensemble de détection d'enveloppe 90 comporte un redresseur 94 et un intégrateur 96 destiné à stabiliser l'affichage et à éviter des alertes trop fugaces.

L'afficheur 92 comporte un indicateur de niveau d'intensité. Cet indicateur peut être un galvanomètre, comme illustré par la Figure 2 ou tout autre système d'affichage, tel qu'un système 97 de diodes électroluminescentes, comme représenté sur la Figure 1.

Dans une variante représentée en pointillés sur la Figure 1, l'ensemble d'affichage 36 est déporté par rapport au support 10. Il est raccordé au support par un moyen de transmission du signal 100 qui peut comprendre un moyen de numérisation, tel qu'un convertisseur et un moyen de transmission vers un écran 101 raccordé à un ordinateur.

Le fonctionnement de l'appareil 10, dans le cadre de la détection de défauts 14 sur une surface 12 va maintenant être décrit.

Initialement, l'appareil 10 est disposé au contact de la surface 12 à contrôler. A cet effet, les organes de contact 50 sont posés sur la surface 12. La cavité 42 s'ouvre alors par l'intermédiaire de l'ouverture 46 en regard d'une région 110 de la surface.

L'espace situé sous l'émetteur 22 et sous le récepteur 26 en regard de la surface 12 est totalement dégagé. La hauteur ΔH séparant l'émetteur 22 et le récepteur 26 de la surface 12 est inférieure à la longueur d'onde d'émission et notamment comprise entre 6 mm et 1,5 mm.

Puis, l'appareil 10 est alimenté électriquement par exemple par une batterie portée par le support 20 ou par une source d'énergie électrique extérieure. L'émetteur 22 est alors activé.

L'oscillateur 62 engendre un signal d'émission à une fréquence d'émission $F_e$ comprise entre 2 GHz et 80 GHz.

Lorsque l'appareil 10 reste immobile sur la surface, le signal d'émission 24 se réfléchit sur la surface 12 et forme un signal reçu 28 qui correspond à la réflexion stable dans le temps 66 liée à l'impédance moyenne de la surface sur l'ensemble de la zone éclairée.

Le signal reçu 28 n'engendre donc pas de composantes caractéristiques d'une variation d'impédance de surface et est filtré par la fréquence de coupure F2 du filtre 72. Comme illustré par la Figure 4, le signal extrait est alors sensiblement constant et égal à 0.

Puis, l'appareil 10 est déplacé tangentiellement par rapport à la surface 12, en faisant glisser les organes d'appui 50 le long de la surface 12. Le déplacement est effectué à une vitesse V généralement comprise entre 1 cm/seconde et 30 cm/seconde.

Lors de ce déplacement, lorsque la surface 12 ne présente aucun défaut significatif d'impédance et que l'émetteur 22 reste à une hauteur sensiblement constante par rapport à la surface 12, le signal reçu reste représentatif de la réflexion stable sur la surface. Ce signal est donc éliminé par le filtre 72, et n'engendre donc aucune variation du signal d'extraction à la sortie de l'unité 34.

Par ailleurs, si des faibles variations de hauteur entre la surface 12 et l'émetteur 22 se produisent, notamment du fait d'une variation de courbure de la surface 12, une composante Doppler provenant de ces variations est susceptible d'être engendrée. La composante Doppler est alors éliminée par le filtre 72, notamment parce qu'elle est à une fréquence inférieure à la fréquence de coupure.

Puis, lorsque l'espace situé en-dessous de la cavité 42 se place au voisinage d'un défaut 14, comprenant par exemple une fissure, un signal réfléchi 68 apparaît avec une incidence faible, notamment inférieure à 45°.

Ce signal engendre une composante fréquentielle Doppler dès que le défaut 14 pénètre dans la zone de contrôle délimitée sous la cavité 42.

Comme illustré par la phase 112 sur la Figure 4, le signal extrait oscille alors fortement à une fréquence $F_r$-$F_e$, caractérisant le décalage Doppler observé à la vitesse de rapprochement $V_r$,

Puis, lors de la phase 113, l'émetteur 22 passe en regard du défaut 14. Comme le défaut 14 se trouve juste au-dessous de l'antenne 60, la vitesse de rapprochement $V_r$ entre le défaut 14 et l'antenne 60 diminue, compte tenu de l'angle d'incidence lors de la phase 113 qui devient voisin de π/2.

La fréquence du signal extrait devient alors inférieure à 5 Hertz qui est la fréquence de coupure choisie pour le filtre 72.

Puis, lors de la phase 114, lorsque l'émetteur 22 passe au-delà du défaut 14, le signal extrait oscille à nouveau fortement, à la fréquence d'oscillation $F_r$-$F_e$ correspondant au décalage Doppler observé.

Le signal extrait par l'unité 34 peut ensuite être transmis à l'unité d'affichage 36 pour être affiché soit sous forme d'une variation continue d'un indicateur de niveau, par exemple représenté par un galvanomètre, soit par une variation discrète d'un indicateur, tel qu'un ensemble de diodes.

En variante, le signal extrait est transmis à une unité 36 d'affichage externe, par exemple à un ordinateur, et est affichée directement sur un écran 101.

L'appareil 10 selon l'invention est très sensible aux variations locales de l'impédance de surface, ce qui permet de détecter des défauts de faibles tailles, qui peuvent être même invisibles à l'oeil nu sur une surface 12. En particulier, de petits défauts de métallisation invisibles à l'oeil nu dans une surface conductrice, et de petits défauts de transparence radioélectrique sur une surface diélectrique sont détectables par l'appareil 10 selon l'invention.

A titre d'exemple, il est possible de détecter des rayures d'une longueur inférieure à 2 mm et, d'une largeur d'un micron présentes dans une couche de métallisation. Il est par ailleurs possible de détecter des défauts de transparence liés à un fil conducteur d'1 mm de long et de diamètre inférieur à 10 microns dans une paroi diélectrique.

La mesure réalisée par l'appareil 10 est très peu sensible à l'environnement d'essai. Ainsi, même si des éléments réflecteurs sont présents au voisinage de l'appareil 10, la mesure n'est pas perturbée, ce qui permet de la réaliser sur site, sans nécessiter de préparation spécifique.

L'appareil 10 est en outre extrêmement compact, et peut être saisi et déplacé par la main d'un utilisateur.

Il présente par exemple une taille comparable à celle d'une souris d'ordinateur, ou à celle d'un téléphone cellulaire. En outre, l'appareil 10 est totalement autonome et ne nécessite pas de calculateur perfectionné pour exploiter les signaux mesurés, contrairement aux techniques de mesure radar.

L'appareil 10 permet ainsi de scanner continûment une surface par glissement du capteur sur la surface, notamment par déplacement manuel.

L'appareil 10 selon l'invention particulièrement performant pour qualifier l'homogénéité des caractéristiques électromagnétiques d'une surface pour des ondes de fréquence supérieures à 300 MHz. Ceci permet de contrôler des parois dont la fonction radioélectrique est de réfléchir, de focaliser, ou de disperser les rayons électromagnétiques.

Dans une variante, le signal extrait de l'unité d'extraction 34, avantageusement numérisé, peut être envoyé vers un calculateur 102. Le calculateur 102 peut afficher son évolution en fonction du temps comme représenté sur la Figure 4. De plus, le calculateur 102 est apte à étalonner le niveau mesuré de la discontinuité d'impédance 14 et à en déduire, à l'aide d'un processus de calibration utilisant une ou plusieurs cibles étalons, une mesure en termes de surface équivalente radar (ou SER) pour chaque discontinuité d'impédance sur la surface 12.

L'appareil 10 selon l'invention, est propre à détecter des niveaux de surface équivalente radar de seulement $10^{-9}\,m^2$, à l'aide d'une réalisation très simple, lorsqu'il fonctionne par exemple à une fréquence voisine de 10 GHz.

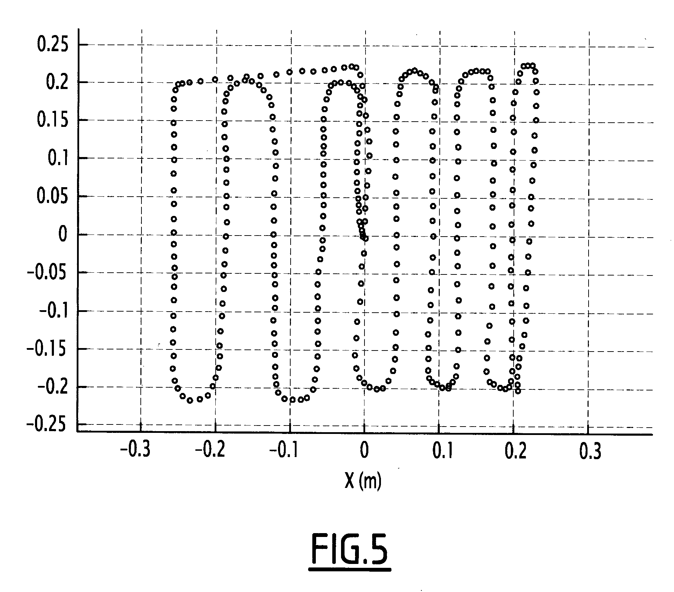

Dans une autre variante, un capteur de position 201 est intégré dans l'appareil 10. Le capteur 201 est déplaçable conjointement avec le support 20. L'unité 30 est alors apte à enregistrer l'intensité du signal extrait par l'unité d'extraction 34 en fonction de la position détectée par le capteur de position 201, et à réaliser des cartographies de discontinuité d'impédances sur une surface, comme représenté sur la Figure 5. Ceci permet de disposer d'une visualisation d'ensemble qui localise et compare les niveaux des discontinuités d'impédances.

Dans une variante avantageuse, la vitesse de déplacement de l'appareil 10 sur le support 12 est également mesurée à l'aide des données du capteur de position 201, ou à l'aide d'un capteur d'accélération séparé pour corriger le signal observé en fonction des variations de vitesse qui affectent l'intensité reçue au travers de la réponse spectrale du filtre 72. Dans ce cas, une calibration peut être effectuée pour déterminer une valeur absolue de réflectivité sur une large plage de vitesse.

Dans encore une autre variante, l'ensemble de guidage 21 comporte des organes de roulement, tels que des roues.

Il est nécessaire dans ce cas d'uniformiser radialement les propriétés radioélectriques des roues pour éviter d'engendrer une composante Doppler provenant de la réflexion des ondes émises par l'émetteur 22 sur les éléments mobiles des organes de roulement relativement aux antennes 60, 64.

Dans encore une autre variante, l'ensemble de guidage 21 est propre à déplacer l'appareil 10 parallèlement à la surface 12, sans placer l'appareil 10 en contact avec la surface 12. Ce déplacement est par exemple effectué par un robot qui assure le guidage mécanique et qui contrôle précisément la distance séparant l'émetteur 22 et le récepteur 26 de la surface 12 pour assurer une mesure reproductible en termes de vitesse et d'écartement.

Grâce à la présence de la cavité interne 42, délimitée vers le haut et à la périphérie de la cavité 42 par la paroi métallique 44 du boîtier creux 40, le champ émis par l'antenne d'émission 60 et le champ réfléchi sur la surface 12 sont confinés dans la cavité 42, la cavité 42 débouchant exclusivement par l'ouverture inférieure 46 placée en regard de la surface 12.

Il est ainsi possible de détecter de très faibles signaux d'intérêt produits par l'interaction de l'onde électromagnétique émise avec les plus petits défauts de la surface 12 à contrôler, en séparant ces signaux d'intérêt de ceux de l'environnement d'essai, tout en conservant une vitesse faible de déplacement sur la surface 12.

Cette faible vitesse de déplacement engendre des décalages Doppler par exemple inférieurs à 100 Hz, voire inférieurs à 50 Hz, par exemple de l'ordre de quelques Hz.

Ceci va à l'encontre des détections Doppler connues qui sont associées à des vitesses élevées de déplacement pour distinguer les signaux d'intérêt des composantes Doppler produites par l'environnement. Ces détections Doppler connues nécessitent de l'espace pour contenir les mouvements, et présentent une sensibilité limitée aux petits défauts.

Dans l'appareil 10 selon l'invention, la détection Doppler réalisée est sensible aux évolutions du signal diffusé à travers l'ouverture 46 du boîtier creux 40.

Ce mode de détection est insensible aux réflexions externes à la région de la surface 12 située en regard de l'ouverture 46 nécessaire pour la détection des petits défauts.

Par ailleurs, ce mode de détection engendre des composantes Doppler qui sont dus à la vitesse d'apparition d'un défaut dans l'ouverture 46 du boîtier 40. Le démasquage progressif du défaut modifie le signal capté par l'unité d'extraction 34.

L'appareil 10 selon l'invention est particulièrement efficace du fait de l'utilisation d'un oscillateur à très faible bruit de phase, tel qu'un oscillateur à résonateur diélectrique

(DRO). Un tel oscillateur garantit une sensibilité adéquate, même si les déplacements sont faibles, et sont à faible vitesse, ce qui engendre des fréquences Doppler de quelques Hz, représentant par exemple un milliardième de la fréquence émise.

## Revendications

1. Appareil (10) de contrôle d'une surface (12), comprenant :

    - un support (20) ;
    - un émetteur (22) porté par le support (20), l'émetteur (22) étant propre à émettre un signal électromagnétique en direction de la surface (12) à une fréquence d'émission ($F_e$);
    - un récepteur (26), destiné à recevoir un signal réfléchi sur la surface (12) ;

    l'appareil (10) comportant un ensemble (21) de guidage du support (20) pour déplacer l'émetteur (22) et le récepteur (26) en regard de la surface (12), tangentiellement par rapport à la surface (12), le support (20) comportant une paroi conductrice (44) délimitant une cavité (42), l'émetteur (22) et le récepteur (26) étant reçus dans la cavité (42), la paroi conductrice (44) délimitant une ouverture inférieure (46) par laquelle débouche la cavité (42), l'ouverture inférieure (46) étant destinée à être positionnée en regard de la surface (12),
    **caractérisé en ce que** l'appareil (10) comporte une unité (34) d'extraction, dans le signal reçu par le récepteur (26) d'une composante fréquentielle ($F_r$-$F_e$) décalée de la fréquence d'émission ($F_e$) résultant d'une variation d'impédance locale de la surface (12), l'unité d'extraction (34) produisant un signal extrait représentatif d'un état de la surface (12) à partir de la composante fréquentielle décalée,
    **en ce que** la composante fréquentielle décalée est représentative d'un décalage Doppler entre la fréquence d'émission et la fréquence de réception à une vitesse de déplacement de l'appareil (10) sur la surface (12),
    et **en ce que** le support (20) comporte au moins un bouclier (47) en matériau absorbant les ondes électromagnétiques à la fréquence d'émission ($F_e$), le bouclier (47) étant disposé dans la cavité (42) délimitée par la paroi conductrice (44), en regard de l'émetteur (22) et du récepteur (26).

2. Appareil (10) selon l'une quelconque des revendications précédentes, **caractérisé en ce que** l'unité d'extraction (34) comporte un mélangeur (80) d'au moins une partie du signal reçu par le récepteur (26) avec au moins une partie du signal d'émission émis par l'émetteur (22) et un composant non linéaire (82) apte à produire un signal traité comportant une oscillation à la composante fréquentielle décalée sur la base du signal combiné obtenu dans le mélangeur (80).

3. Appareil (10) selon la revendication 2, **caractérisé en ce qu'**il comporte un filtre fréquentiel (72) propre à éliminer les fréquences inférieures à une fréquence minimale de coupure, avantageusement égale à 2 $V_{min}$ Fe/c, où $V_{min}$ est un minorant de la vitesse de déplacement de l'appareil (10) sur la surface (12), $F_e$ est la fréquence d'émission, et c est la vitesse du rayonnement électromagnétique dans le vide, le filtre fréquentiel (72) étant propre à éliminer les fréquences supérieures à une fréquence supérieure de coupure, notamment égale à 2 $V_{max}$ $F_e$/c où $V_{max}$ est un majorant de la vitesse de déplacement de l'appareil (10) sur la surface (12).

4. Appareil (10) selon l'une quelconque des revendications précédentes, comportant une unité d'affichage (36) propre à afficher un signal d'intensité variable en fonction de l'état de la surface (12), le signal d'intensité variable étant produit à partir du signal extrait dans l'unité d'extraction (34).

5. Appareil (10) selon la revendication 4, **caractérisé en ce que** l'unité d'affichage (36) comporte un ensemble de traitement du signal extrait obtenu à la sortie de l'unité d'extraction (34), l'ensemble de traitement comportant un détecteur d'enveloppe (90) comportant avantageusement un redresseur (94) et un intégrateur (96).

6. Appareil (10) selon l'une quelconque des revendications précédentes, **caractérisé en ce qu'il** comporte un convertisseur analogique-numérique propre à numériser le signal extrait issu de l'unité d'extraction (34).

7. Appareil (10) selon l'une quelconque des revendications précédentes, **caractérisé en ce qu'il** comporte un capteur (201) de détection de la position de l'appareil (10) sur la surface (12), l'appareil (10) comportant avantageusement un ensemble de mémorisation du signal extrait obtenu par l'unité d'extraction (34) en fonction de la position de l'appareil (10) sur la surface (12).

8. Appareil (10) selon l'une quelconque des revendications précédentes, **caractérisé en ce que** le support (20) est portable pour être saisi dans la main d'un utilisateur.

**9.** Appareil (10) selon l'une quelconque des revendications précédentes, **caractérisé en ce que** l'ensemble de guidage (21) comporte au moins un patin (54) de glissement ou/et un organe de roulage propre à maintenir l'émetteur (22) et le récepteur (26) à une distance sensiblement constante en regard de la surface (12), lors du déplacement tangentiel du support (20) sur la surface (12).

**10.** Appareil (10) selon l'une quelconque des revendications 1 à 8, **caractérisé en ce que** l'ensemble de guidage (21) comporte un mécanisme de guidage piloté du support (20) en regard de la surface (12), maintenant avantageusement l'appareil (10) à l'écart de la surface (12).

**11.** Appareil (10) selon l'une quelconque des revendications précédentes, **caractérisé en ce que** la paroi conductrice (44) délimite la cavité vers le haut à l'écart de la surface (12) et à la périphérie de la cavité (42) autour de l'émetteur (22) et du récepteur (26), le bouclier (47) s'étendant à la périphérie de la cavité (42), autour de l'émetteur (22) et du récepteur (26).

**12.** Procédé de contrôle d'une surface (12), **caractérisé en ce qu'**il comporte les étapes suivantes :

- fourniture d'un appareil (10) selon l'une quelconque des revendications précédentes ;
- déplacement tangentiel du support (20) en regard de la surface (12) par l'intermédiaire de l'ensemble de guidage (21) ;
- émission d'un signal électromagnétique à une fréquence d'émission ($F_e$) par l'émetteur (22) ;
- réception d'un signal réfléchi sur la surface (12) par le récepteur (26);
- extraction, par l'unité d'extraction (34), d'une composante fréquentielle décalée de la fréquence d'émission dans le signal reçu par le récepteur, la composante fréquentielle décalée résultant d'une variation d'impédance locale de la surface (12) ;
- production d'un signal extrait représentatif d'un état de la surface à partir de la composante fréquentielle extraite.

**13.** Procédé selon la revendication 12, **caractérisé en ce que** l'étape d'extraction comporte le mélange d'au moins une partie du signal de réception reçu par le récepteur (26) avec au moins une partie du signal d'émission émis par l'émetteur (22) pour former un signal combiné, et l'application du signal combiné à un composant non linéaire (82) pour produire un signal extrait oscillant à la composante fréquentielle décalée.

**Patentansprüche**

**1.** Vorrichtung (10) zum Kontrollieren einer Oberfläche (12) aufweisend:

- ein Gestell (20);
- einen Sender (22), der von dem Gestell (20) getragen wird, wobei der Sender (22) geeignet ist, ein elektromagnetisches Signal in Richtung der Oberfläche (12) mit einer Sendefrequenz ($F_e$) zu senden;
- einen Empfänger (26), der dazu vorgesehen ist, ein auf der Oberfläche reflektiertes Signal (12) zu empfangen;

wobei die Vorrichtung (10) eine Anordnung (21) zum Führen des Gestells (20) zum Bewegen des Senders (22) und des Empfängers (26) gegenüber der Oberfläche (12) tangential bezüglich der Oberfläche (12) aufweist, wobei das Gestell (20) eine leitende Wand (44), die einen Hohlraum (42) begrenzt, aufweist, wobei der Sender (22) und der Empfänger (26) in dem Hohlraum (42) enthalten sind, wobei die leitende Wand (44) eine untere Öffnung (46), durch die der Hohlraum geöffnet ist, begrenzt, wobei die untere Öffnung (46) dazu vorgesehen ist, gegenüber der Oberfläche (12) positioniert zu werden, dadurch charakterisiert, dass die Vorrichtung (10) eine Einheit (34) zum Extrahieren, aus dem von dem Empfänger (26) empfangenen Signal, einer Frequenzkomponente ($F_r$-$F_e$), die von der Sendefrequenz ($F_e$) verschoben ist und aus einer lokalen Änderung der Impedanz der Oberfläche (12) resultiert, aufweist, wobei die Einheit zum Extrahieren (34) ausgehend von der verschobenen Frequenzkomponente ein extrahiertes Signal erzeugt, das repräsentativ für einen Zustand der Oberfläche (12) ist, dadurch, dass die verschobene Frequenzkomponente repräsentativ für eine Dopplerverschiebung zwischen der Sendefrequenz und der Empfangsfrequenz bei einer Bewegungsgeschwindigkeit der Vorrichtung (10) auf der Oberfläche (12) ist, und dadurch, dass das Gehäuse (20) mindestens eine Abschirmung (47) aus Material aufweist, das elektromagnetischen Wellen mit der Sendefrequenz ($F_e$) absorbiert, wobei die Abschirmung (47) in dem Hohlraum (42), der von der leitenden Wand (44) begrenzt ist, gegenüber von dem Sender (22) und dem Empfänger (26) angeordnet ist.

**2.** Vorrichtung (10) gemäß einem der vorhergehenden Ansprüche, dadurch charakterisiert, dass die Einheit zum Extrahieren (34) einen Mischer (80) mindestens eines Teils des von dem Empfänger (26) empfangenen Signals mit mindestens einem Teil des von dem Sender gesendeten Sendesignals (22) und ein nichtlineares Bauelement (82) aufweist, das eingerichtet ist, basierend auf dem in dem Mischer (80) erhaltenen kombinierten Signal ein verarbeitetes Signal zu Erzeugen, das eine Schwingung bei der verschobenen Frequenzkomponente aufweist.

3. Vorrichtung (10) gemäß Anspruch 2, dadurch charakterisiert, dass es einen Frequenzfilter (72) aufweist, der eingerichtet ist, die Frequenzen zu eliminieren, die unter einer minimalen Grenzfrequenz liegen, bevorzugt gleich 2 $V_{min}$ Fe/c, wobei $V_{min}$ eine Minorante der Bewegungsgeschwindigkeit der Vorrichtung (10) auf der Oberfläche (12) ist, $F_e$ die Sendefrequenz ist und c die Geschwindigkeit elektromagnetischer Strahlung im Vakuum ist, wobei der Frequenzfilter (72) eingerichtet ist, die Frequenzen zu eliminieren, die über einer oberen Grenzfrequenz liegen, insbesondere gleich 2 $V_{max}$ Fe/c, wobei $V_{max}$ eine Majorante der Bewegungsgeschwindigkeit der Vorrichtung (10) auf der Oberfläche (12) ist.

4. Vorrichtung (10) gemäß einem der vorhergehenden Ansprüche, aufweisend eine Anzeigeeinheit (36), die eingerichtet ist, ein Signal mit variabler Intensität als Funktion des Zustands der Oberfläche (12) anzuzeigen, wobei das Signal mit variabler Intensität ausgehend von dem von der Einheit zur Extraktion (34) extrahierten Signal erzeugt wird.

5. Vorrichtung (10) gemäß Anspruch 4, dadurch charakterisiert, dass die Anzeigeeinheit (36) eine Anordnung zum Verarbeiten des am Ausgang der Einheit zur Extraktion (34) erhaltenen extrahierten Signals enthält, wobei die Anordnung zum Verarbeiten einen Hülldetektor (90) enthält, der bevorzugt einen Gleichrichter und einen Integrator aufweist.

6. Vorrichtung (10) gemäß einem der vorhergehenden Ansprüche, dadurch charakterisiert, dass sie einen Analog-Digital-Wandler aufweist, der eingerichtet ist, das von der Einheit zum Extrahieren (34) ausgegebene Signal zu digitalisieren.

7. Vorrichtung (10) gemäß einem der vorhergehenden Ansprüche, dadurch charakterisiert, dass sie einen Sensor (201) zum Detektieren der Position der Vorrichtung (10) auf der Oberfläche (12) aufweist, wobei die Vorrichtung (10) bevorzugt eine Anordnung zum Speichern des durch die Einheit zur Extraktion (34) erhaltenden Signals in Funktion der Position der Vorrichtung (10) auf der Oberfläche (12) aufweist.

8. Vorrichtung (10) gemäß einem der vorhergehenden Ansprüche, dadurch charakterisiert, dass das Gestell (20) tragbar ist, so dass es in die Hand eines Benutzers genommen werden kann.

9. Vorrichtung (10) gemäß einem der vorhergehenden Ansprüche, dadurch charakterisiert, dass die Anordnung zum Führen (21) mindestens eine Gleitkufe (54) und/oder ein Rollelement aufweist, geeignet, den Sender (22) und den Empfänger (26) bei einer tangentialen Bewegung des Gestells (20) auf der Oberfläche (12) in einem im Wesentlichen konstanten Abstand gegenüber der Oberfläche (12) zu halten.

10. Vorrichtung (10) gemäß einem der Ansprüche 1 bis 8, dadurch charakterisiert, dass die Anordnung zum Führen (21) einen von dem Gestell (20) gesteuerten Mechanismus zum Führen gegenüber der Oberfläche (12) aufweist, der bevorzugt die Vorrichtung auf Abstand von der Oberfläche (12) hält.

11. Vorrichtung (10) gemäß einem der vorhergehenden Ansprüche, dadurch charakterisiert, dass die leitende Wand (44) den Hohlraum nach oben im Abstand der Oberfläche (12) und am Rand des Hohlraums (42) um den Sender (22) und den Empfänger (26) begrenzt, wobei die Abschirmung (47) sich am Rand des Hohlraums (42) um den Sender (22) und den Empfänger (26) erstreckt.

12. Verfahren zum Kontrollieren einer Oberfläche (12), dadurch charakterisiert, dass sie die folgenden Schritte aufweist:

   - Bereitstellen einer Vorrichtung (10) gemäß einem der vorhergehenden Ansprüche;
   - tangentiales Bewegen des Gestells (20) gegenüber der Oberfläche (12) mittels der Anordnung zum Führen (21);
   - Senden eines elektromagnetischen Signals mit einer Sendefrequenz ($F_e$) durch den Sender (22);
   - Empfangen eines auf der Oberfläche (12) reflektierten Signals durch den Empfänger (26);
   - Extrahieren, durch die Einheit zum Extrahieren (34) einer Frequenzkomponente in dem von dem Empfänger empfangenen Signal, die von der Sendefrequenz verschoben ist, wobei die verschobene Frequenzkomponente aus einer lokalen Änderung der Impedanz der Oberfläche (12) resultiert;
   - Erzeugen eines extrahierten Signals, das repräsentativ für einen Zustand der Oberfläche ist, ausgehend von der extrahierten Frequenzkomponente.

13. Verfahren gemäß Anspruch 12, dadurch charakterisiert, dass der Extraktionsschritt das Mischen mindestens eines Teils des von dem Empfänger (26) empfangenen Empfangssignals mit mindestens einem Teil des von dem Sender (22) gesendeten Sendesignals zum Bilden eines kombinierten Signals und das Zuführen des kombinierten Signals zu einem nichtlinearen Bauelement (82) zum Erzeugen eines extrahierten Signals, das mit der verschobenen Frequenzkomponente schwingt, aufweist.

## Claims

1. A device (10) for testing a surface (12), comprising:

   - a holder (20);
   - a transmitter (22) supported by the holder (20), the transmitter (22) being able to transmit an electromagnetic signal to the surface (12) at a transmission frequency ($F_e$);
   - a receiver (26) for receiving a signal reflected on the surface (12);

   the device (10) comprising a guide assembly (21) for the holder (20) to move the transmitter (22) and the receiver (26) across from the surface (12), tangentially relative to the surface (12), the holder (20) comprising a conductive wall (44) delimiting a cavity (42), the transmitter (22) and the receiver (26) being received in the cavity (42);
   the conductive wall (44) delimiting a lower opening (46) through which the cavity (42) opens, the lower opening (46) being designed to be positioned across from the surface (12); **characterized in that** the device (10) comprises an extraction unit (34) for extracting a shifted frequency component ($F_r$-$F_e$) of the transmission frequency ($F_e$) resulting from a local impedance variation of the surface (12) in the signal received by the receiver (26), the extraction unit (34) producing an extracted signal that is representative of a state of the surface (12) from the shifted frequency component, **in that** the shifted frequency component is representative of a Doppler shift between the transmission frequency and the reception frequency at a speed of travel of the device (10) on the surface (12) and **in that** the holder (20) comprises at least one shield (46) made from a material absorbing the electromagnetic waves at the transmission frequency ($F_e$), the shield (46) being positioned in the cavity (42) delimited by the conductive wall (44), across from the transmitter (22) and the receiver (26).

2. The device (10) according to any one of the preceding claims, **characterized in that** the extraction unit (34) comprises a mixer (80) for mixing at least part of the signal received by the receiver (26) with at least part of the transmission signal transmitted by the transmitter (22) and a nonlinear component (82) capable of producing a processed signal comprising an oscillation at the shifted frequency component based on the combined signal obtained in the mixer (80).

3. The device (10) according to claim 2, **characterized in that** it comprises a frequency filter (72) capable of eliminating the frequencies below a minimum cutoff frequency, advantageously equal to 2 $V_{min}$ Fe/c, where $V_{min}$ is a lower bound of the speed of movement of the device (10) on the surface (12), $F_e$ is the transmission frequency, and c is the speed of the electromagnetic radiation in the vacuum, the frequency filter (72) being capable of eliminating frequencies above an upper cutoff frequency, in particular equal to 2 $V_{max}$ $F_e$/c where $V_{max}$ is an upper bound of the speed of movement of the device (10) on the surface (12).

4. The device (10) according to any one of the preceding claims, **characterized in that** it comprises a display unit (36) capable of displaying a variable intensity signal as a function of the state of the surface (12), the variable intensity signal being produced from the signal extracted in the extraction unit (34).

5. The device (10) according to claim 4, **characterized in that** the display unit (36) comprises a processing assembly for processing the extracted signal obtained as output from the extraction unit (34), the processing assembly comprising an enclosure detector (90) advantageously comprising a rectifier (92) and an integrator (94).

6. The device (10) according to any one of the preceding claims, **characterized in that** it comprises an analog-digital converter capable of digitizing the extracted signal from the extraction unit (34).

7. The device (10) according to any one of the preceding claims, **characterized in that** it comprises a detection sensor (201) for detecting the position of the device (10) on the surface (12), the device (10) advantageously comprising an assembly for storing the extracted signal obtained by the extraction unit (34) as a function of the position of the device (10) on the surface (12).

8. The device (10) according to any one of the preceding claims, **characterized in that** the holder (20) is portable to be grasped in a user's hand.

9. The device (10) according to any one of the preceding claims, **characterized in that** the guide assembly (21) comprises at least one skid (54) and/or a rolling member capable of keeping the transmitter (22) and the receiver (26) at a substantially constant distance across from the surface (12), during the tangential movement of the holder (20) on the surface (12).

10. The device (10) according to any one of claims 1 to 8, **characterized in that** the guide assembly (21) comprises a guide mechanism driven from the holder (20) across from the surface (12), advantageously keeping the device (10) separated from the surface (12).

**11.** Apparatus (10) according to any one of the preceding claims, **characterized in that** the conductive wall (44) delimits upwardly the cavity apart from the surface (12) and at the periphery of the cavity (42) around the transmitter (22) and the receiver (26), the shield (47) extending at the periphery of the cavity (42) around the transmitter (22) and the receiver (26).

**12.** A method for testing a surface (12), **characterized in that** it comprises the following steps:

- providing a device (10) according to any one of the preceding claims;
- tangential movement of the holder (20) across from the surface (12) by means of the guide assembly (21);
- transmission of an electromagnetic signal at a transmission frequency ($F_e$) by the transmitter (22);
- reception of a reflected signal on the surface (12) by the receiver (26);
- extraction, by the extraction unit (34), of a shifted frequency component of the transmission frequency in the signal received by the receiver, the shifted frequency component resulting from a local impedance variation of the surface (12);
- production of an extracted signal representative of a state of the surface from the extracted frequency component.

**13.** The method according to claim 12, **characterized in that** the extraction step comprises mixing at least part of the reception signal received by the receiver (26) with at least part of the transmission signal transmitted by the transmitter (22) to form a combined signal, and the application of the combined signal to a nonlinear component (82) to produce an oscillating extracted signal at the shifted frequency component.

FIG.1

EP 2 600 141 B1

FIG.2

FIG.4

FIG.3

FIG.5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2003132760 A
- US 4123703 A
- US 2999982 A